(19) **Europäisches Patentamt / European Patent Office / Office européen des brevets**

(11) **EP 4 604 461 A1**

(12) **EUROPEAN PATENT APPLICATION**
published in accordance with Art. 153(4) EPC

(43) Date of publication:
**20.08.2025 Bulletin 2025/34**

(21) Application number: **23896029.8**

(22) Date of filing: **30.06.2023**

(51) International Patent Classification (IPC):
***H04L 25/49*** (2006.01)

(52) Cooperative Patent Classification (CPC):
**H04B 1/04; H04B 1/66; H04L 25/49**

(86) International application number:
**PCT/CN2023/105402**

(87) International publication number:
**WO 2024/113866 (06.06.2024 Gazette 2024/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **02.12.2022 CN 202211544594**

(71) Applicant: **ZTE CORPORATION**
**Shenzhen, Guangdong 518057 (CN)**

(72) Inventor: **YANG, Zhen**
**Shenzhen, Guangdong 518057 (CN)**

(74) Representative: **Ziebig Hengelhaupt Intellectual Property Attorneys**
**Patentanwaltskanzlei PartGmbB**
**Leipziger Straße 49**
**10117 Berlin (DE)**

(54) **DIGITAL PRE-DISTORTION PROCESSING METHOD AND APPARATUS, AND TERMINAL DEVICE AND COMPUTER STORAGE MEDIUM**

(57) The present application relates to the technical field of wireless communications. Disclosed are a digital pre-distortion processing method and apparatus, and a terminal device and a computer storage medium. The digital pre-distortion processing method comprises: receiving original input data of a radio-frequency power amplifier; pre-processing the original input data to obtain compressed data; and performing nonlinear processing on the compressed data, so as to obtain output data as actual input data of the radio-frequency power amplifier.

```
                                                                      ┌─ S10
┌─────────────────────────────────────────────────────────────┐
│   receiving original input data of a radio-frequency power amplifier │
└─────────────────────────────────────────────────────────────┘
                              │
                              ▼
                                                                      ┌─ S20
┌─────────────────────────────────────────────────────────────┐
│   pre-processing the original input data to obtain compressed data  │
└─────────────────────────────────────────────────────────────┘
                              │
                              ▼
                                                                      ┌─ S30
┌─────────────────────────────────────────────────────────────┐
│   performing nonlinear processing on the compressed data, so as to  │
│   obtain output data as actual input data of the radio-frequency power │
│   amplifier                                                   │
└─────────────────────────────────────────────────────────────┘
```

Fig. 3

EP 4 604 461 A1

## Description

### CROSS-REFERENCE TO RELATED APPLICATIONS

The present application is proposed based on and claims priority to Chinese Application No. 202211544594.3, filed on December 2, 2022, the disclosure of which is hereby incorporated by reference in its entirety.

### TECHNICAL FIELD

The present application relates to the technical field of wireless communications, and in particular to a digital pre-distortion processing method, apparatus, terminal device and computer storage medium.

### BACKGROUND

Nowadays, DPD (Digital pre-distortion) technology has been widely used in wireless communication systems. For example, a DPD module is cascaded with radio-frequency power amplifier to solve the nonlinear and memorability problems of the radio-frequency power amplifier based on the nonlinear and memorability of the DPD module.

However, the existing DPD modules cascaded with the radio-frequency power amplifier usually adopt DPD models based on neural networks, such as MP (Memory Polynomial) model and GMP (Generalized Memory Polynomial) model. However, DPD models based on neural networks such as MP and GMP generally have the defect of large number of parameters, which makes the overall model training difficult.

Based on this, how to overcome the defect of a large number of DPD model parameters in the existing DPD module that makes model training difficult, to improve the performance of the DPD model, has become a technical problem that needs to be solved in this field.

### SUMMARY

The main purpose of the present application is to provide a digital pre-distortion processing method, apparatus, terminal device and computer storage medium, aiming to overcome the defect that the existing DPD model parameters of the DPD module cascaded with the radio-frequency power amplifier are large, resulting in difficulty in model training, thereby improving the performance of the DPD model.

To achieve the above purpose, the present application provides a digital pre-distortion processing method, the digital pre-distortion processing method comprising:

receiving original input data of a radio-frequency power amplifier;

pre-processing the original input data to obtain compressed data; and

performing nonlinear processing on the compressed data, so as to obtain output data as actual input data of the radio-frequency power amplifier.

In addition, to achieve the above purpose, the present application also provides a digital pre-distortion processing apparatus, the digital pre-distortion processing apparatus comprising:

a data receiving module, configured to receive original input data of a radio-frequency power amplifier;

a pre-processing module, configured to pre-process the original input data to obtain compressed data; and

a data nonlinear processing module, configured to perform nonlinear processing on the compressed data, so as to obtain output data as actual input data of the radio-frequency power amplifier.

Wherein each function of the digital pre-distortion processing apparatus provided by the present application implements the steps of the digital pre-distortion processing method described above during operation.

In addition, to achieve the above purpose, the present application also provides a terminal device, the terminal device comprising: a memory, a processor, and a pre-distortion processing program stored in the memory and executable on the processor, the digital pre-distortion processing program implementing the steps of the digital pre-distortion processing method described above when executed by the processor.

In addition, to achieve the above purpose, the present application also provides a computer storage medium, the computer storage medium storing a digital pre-distortion processing program, the digital pre-distortion processing program implementing the steps of the digital pre-distortion processing method described above when executed by the processor.

In addition, to achieve the above purpose, the present application also provides a computer program product, the computer program product comprises a computer program, and when the computer program is executed by a processor, implementing the steps of the digital pre-distortion processing method described above.

The present application provides a digital pre-distortion processing method, apparatus, terminal device, computer storage medium and computer program product. In the embodiments of the present application, the present application uses a DPD module to receive the original input data for the radio-frequency power amplifier before the radio-frequency power amplifier performs power amplification on the wireless signal; then, the DPD module uses a DPD model to directly pre-process the original input data on the input side to obtain compressed data; finally, the DPD module further performs nonlinear processing on the compressed data, so as to obtain output data as the actual input data that is finally transmitted to the radio-frequency power amplifier for power amplification.

In this way, the present application uses the DPD model to start directly from the input side of the radio-frequency power amplifier and perform a compression pre-processing operation on the original input data of the radio-frequency power amplifier, which can eliminate redundant information in the original input data and reduce the dimension of the data, thereby reducing the number of model parameters, thereby effectively overcoming the defect that the large number of DPD model parameters of the existing DPD module cascaded with the radio-frequency power amplifier makes model training difficult, and improves the performance of model training.

## BRIEF DESCRIPTION OF DRAWINGS

FIG. 1 is a schematic diagram of the device structure of the hardware operating environment of the terminal device involved in the embodiment of the present application;

FIG. 2 is a schematic diagram of the principle of the DPD module involved in the embodiment of the present application performing digital pre-distortion processing;

FIG. 3 is a schematic diagram of the step flow of the embodiment of the digital pre-distortion processing method of the present application;

FIG. 4 is a schematic diagram of the structure of a DPD model involved in the embodiment of the digital pre-distortion processing method of the present application;

FIG. 5 is a schematic diagram of the table lookup scenario involved in the embodiment of the digital pre-distortion processing method of the present application;

FIG. 6 is a schematic diagram of the structure of another DPD model involved in the embodiment of the digital pre-distortion processing method of the present application;

FIG. 7 is a schematic diagram of the structure of another DPD model involved in the embodiment of the digital pre-distortion processing method of the present application;

FIG. 8 is a schematic diagram of the structure of a neural network-based DPD model involved in the embodiment of the digital pre-distortion processing method of the present application;

FIG. 9 is a CDF (Cumulative Distribution Function) curve involved in the embodiment of the digital pre-distortion processing method of the present application;

FIG. 10 is a schematic diagram of the module structure of the embodiment of the digital pre-distortion processing apparatus of the present application.

The realization of the purpose, functional features and advantages of the present application will be further explained in conjunction with the embodiments and with reference to the accompanying drawings.

## DETAILED DESCRIPTION

It should be understood that the specific embodiments described herein are only used to explain the present application and are not used to limit the present application.

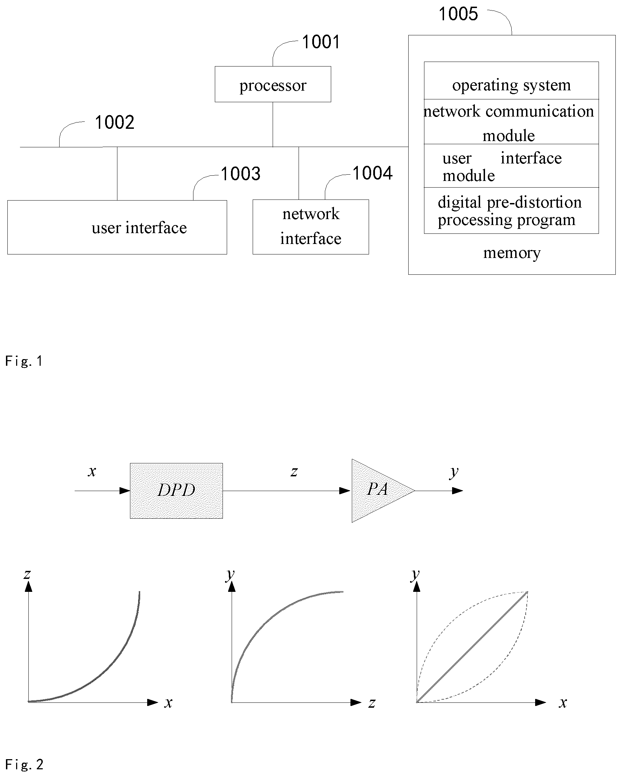

Referring to FIG. 1, which is a schematic diagram of the device structure of the hardware operating environment of the terminal device provided by the embodiment of the present application.

In the embodiment of the present application, the terminal device provided by the present application may be a terminal device cascaded with a radio-frequency power amplifier as a DPD module. Alternatively, the terminal device provided by the present application may also be a terminal device integrated with a DPD module to perform digital pre-distortion processing on the original input data that needs to be amplified by the radio-frequency power amplifier.

As shown in FIG. 1, the terminal device provided in the present application may comprise: a processor 1001, such as a CPU, a communication bus 1002, a user interface 1003, a network interface 1004, and a memory 1005. Among them, the communication bus 1002 is used to realize the connection and communication between these components. The user interface 1003 may comprise a display, an input unit, such as a keyboard, and the user interface 1003 may also comprise a standard wired interface and a wireless interface. The network interface 1004 may comprise a standard wired interface and a wireless interface (such as a Wi-Fi interface). The memory 1005 may be a high-speed RAM memory, or a stable memory (non-volatile memory), such as a disk memory. The memory 1005 may also be a storage apparatus independent of the aforementioned processor 1001.

Those skilled in the art can understand that the structure shown in FIG. 1 does not constitute a limitation on the terminal device, and the terminal device provided in the present application may comprise more or fewer components than shown in the figure, or combine certain components, or arrange components differently.

As shown in FIG. 1, the memory 1005 as a computer storage medium may comprise an operating system, a network communication module, a user interface module, and a digital pre-distortion processing program.

In the terminal shown in FIG. 1, the network interface 1004 is mainly used to connect to the backend server and perform data communication with the backend server; the user interface 1003 is mainly used to connect to the client and perform data communication with the client; and the processor 1001 can be used to call the digital pre-distortion processing program stored in the memory 1005 and perform the following steps:

receiving the original input data of the radio-frequency power amplifier;

pre-processing the original input data to obtain the compressed data; and

performing nonlinear processing on the compressed data, so as to obtain the output data as actual input data of the radio-frequency power amplifier.

In one implementation, the compressed data comprises first compressed data, and the processor 1001 may also be used to call the digital pre-distortion processing program stored in the memory 1005 and perform the following steps:

using the original input data as model input of a preset DPD model, wherein the DPD model comprises a first data pre-processing module;

compressing the model input through the first data pre-processing module to obtain the first compressed data.

In one implementation, the processor 1001 may also be used to call the digital pre-distortion processing program stored in the memory 1005 and perform the following steps:
performing linear compression on the model input based on a preset compression matrix through the first data pre-processing module to obtain the first compressed data.

In one implementation, the processor 1001 may also be used to call the digital pre-distortion processing program stored in the memory 1005 and perform the following steps:

calculating the autocorrelation matrix of the original input data;

generating a compression matrix according to the autocorrelation matrix and target output data dimension corresponding to the first data pre-processing module.

In one implementation, the processor 1001 may also be used to call the digital pre-distortion processing program stored in the memory 1005 and perform the following steps:

obtaining data before compression corresponding to the original input data based on restoration of preset restoration matrix;

calculating mean square error between the original input data and the data before compression;

determining the target output data dimension corresponding to the first data pre-processing module according to the relationship between the mean square error and a preset error threshold.

In one implementation, the processor 1001 may also be used to call the digital pre-distortion processing program stored in the memory 1005 and perform the following steps
determining a compression matrix corresponding to signal bandwidth of the original input data from a preset compression matrix table, wherein the compression matrix table comprises a plurality of compression matrices corresponding to different signal bandwidths, respectively.

In one implementation, the compressed data further comprises second compressed data, and the DPD model further comprises a second data pre-processing module; the processor 1001 may also be used to call the digital pre-distortion processing program stored in the memory 1005, and perform the following steps:

compressing the modulus value of the model input through the second data pre-processing module to obtain the second compressed data; and

performing nonlinear processing on the first compressed data and the second compressed data through the DPD model.

In the embodiment of the present application, the RF power amplifier (full name radio-frequency power amplifier) is an important component in the wireless communication system, and its function is to amplify the power of the wireless signal to the target value and then feed it into the antenna. The radio-frequency power amplifier has two characteristics: memory and nonlinearity. Among them, the main manifestation of the nonlinearity of the radio-frequency power amplifier is that the gain of the input wireless signal during power amplification will gradually decrease as the power of the wireless signal increases. This characteristic will cause the constellation diagram of the signal to be distorted, especially for OFDM (Orthogonal Frequency Division Multiplexing) wireless signals with such high PAPR (Peak to Average Power Ratio, referred to as peak-to-average ratio). In addition, the memorability of the radio-frequency power amplifier means that the output of the radio-frequency power amplifier is not only related to the wireless signal input at the current moment, but also to the wireless signal input to the radio-frequency power amplifier at the previous moment. The influence of memorability is related to the bandwidth of the signal, that is, the larger the bandwidth of the signal, the greater the influence of memorability, and thus it cannot be ignored.

As shown in FIG. 2, the best solution to the nonlinearity and memorability problems of power amplifiers is the DPD technology, whose principle is to add a DPD module in front of the radio-frequency power amplifier. Since the DPD module also has nonlinearity and memorability, the DPD module and the radio-frequency power amplifier are cascaded together to offset the nonlinearity and memorability of the two modules, ultimately achieving the effect of linear amplification of the original wireless signal.

However, the existing DPD modules cascaded with the radio-frequency power amplifier usually adopt DPD models based on neural networks, such as the MP model and the GMP model. However, these neural network-based DPD models such as MP and GMP generally have the defect of a large number of parameters, which makes the overall model training difficult.

Based on this, how to overcome the defect of a large number of DPD model parameters in the existing DPD module that makes model training difficult, to improve the performance of the DPD model, has become a technical problem that needs to be solved urgently in this field.

Based on this, how to overcome the defect of large number of DPD model parameters in the existing DPD module which makes model training difficult and improve the performance of the DPD model has become a technical problem that needs to be solved urgently in this field.

In response to the above problems, the present application provides a digital pre-distortion processing method, which uses a DPD module to receive the original input data for the radio-frequency power amplifier before the radio-frequency power amplifier performs power amplification on the wireless signal; then, the DPD module uses a DPD model to directly pre-process the original input data on the input side to obtain compressed data; finally, the DPD module further performs nonlinear processing on the compressed data, so as to obtain output data as the actual input data that is finally transmitted to the radio-frequency power amplifier for power amplification.

In this way, the digital pre-distortion processing method of the present application uses the DPD model to start directly from the input side of the radio-frequency power amplifier and perform a compression pre-processing operation on the original input data of the radio-frequency power amplifier, which can eliminate redundant information in the original input data and reduce the dimension of the data, thereby reducing the number of model parameters, thereby effectively overcoming the defect that the large number of DPD model parameters of the existing DPD module cascaded with the radio-frequency power amplifier makes model training difficult, and improves the performance of model training.

Based on the overall concept of the digital pre-distortion processing method of the present application, various embodiments of the digital pre-distortion processing method of the present application are proposed.

In the embodiment of the present application, the digital pre-distortion processing method of the present application is applied to the DPD module cascaded with the radio-frequency power amplifier, or the digital pre-distortion processing method of the present application is applied to the terminal device integrated with the DPD module. For ease of understanding, the following text will use the DPD module as the execution subject to explain the digital pre-distortion processing method of the present application.

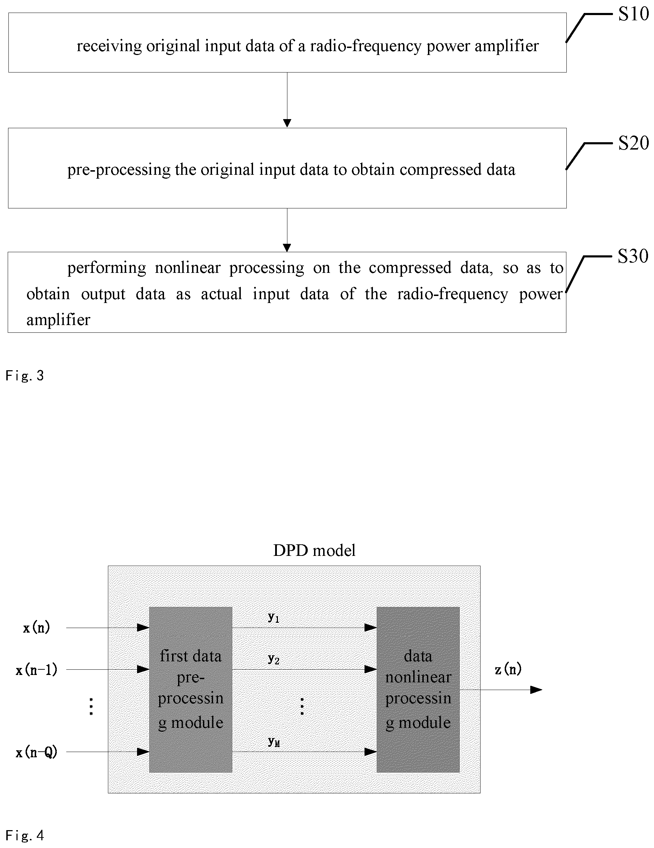

Please refer to FIG. 3, which is a flowchart of the first embodiment of the digital pre-distortion processing method. It should be noted that although the logical order is shown in the flowchart, in some cases, the digital pre-distortion processing method of the present application can of course perform the steps shown or described in a different order from that here.

As shown in FIG. 3, the digital pre-distortion processing method of the present application may comprise the following steps:

Step S10, receiving original input data of a radio-frequency power amplifier;

In this embodiment, since the DPD module is cascaded at the front end of the radio-frequency power amplifier, when the external device sends a wireless signal to the radio-frequency power amplifier, the DPD module first receives the wireless signal for the radio-frequency power amplifier to obtain the original input data that needs to be power amplified by the radio-frequency power amplifier.

Step S20, pre-processing the original input data to obtain compressed data;

In this embodiment, after the DPD module receives the wireless signal before the radio-frequency power amplifier to obtain the original input data, the DPD module further starts to call the DPD model configured by itself to perform pre-processing comprising at least data compression on the original input data, thereby obtaining the compressed data of the original input data.

In this embodiment, the pre-processing comprises at least data compression. Based on different design requirements of practical applications, the DPD module can of course also perform other types of processing operations, such as noise elimination, on the above-mentioned original input data. Based on this, the digital pre-distortion processing method of the present application does not limit the specific type of pre-processing of the original input data by the DPD module.

Step S30, performing nonlinear processing on the compressed data, so as to obtain output data as actual input data of the radio-frequency power amplifier.

In this embodiment, after the DPD module pre-processes the above original input data by calling the DPD model to obtain the compressed data of the original input data, the DPD module further performs nonlinear processing on the compressed data by calling the DPD model. Then, the DPD module uses the output data obtained after nonlinear processing of the compressed data as the actual input data of the radio-frequency power amplifier, and further transmits the actual input data backwards to the radio-frequency power amplifier, so that the radio-frequency power amplifier amplifies the power of the actual input data and feeds it into the antenna.

In this embodiment, the digital pre-distortion processing method of the present application first receives original input data that needs to be power amplified by the radio-frequency power amplifier through the DPD module. Then, the DPD module calls the DPD model configured by itself to perform pre-processing on the original input data comprising at least data compression, thereby obtaining the compressed data of the original input data. Then, the DPD module further calls the DPD model to perform nonlinear processing on the compressed data, and uses the output data obtained after the nonlinear processing on the compressed data as the actual input data of the RF power amplifier, so as to continue to pass the actual input data backward to the radio-frequency power amplifier, so that the radio-frequency power amplifier amplifies the power of the actual input data and feeds it into the antenna.

In this way, the present application uses the DPD model to start directly from the input side of the radio-frequency power amplifier and perform a compression pre-processing operation on the original input data of the radio-frequency power amplifier, which can eliminate redundant information in the original input data and reduce the dimension of the data, thereby reducing the number of model parameters, thereby effectively overcoming the defect that the large number of DPD model parameters of the existing DPD module cascaded with the radio-frequency power amplifier makes model training difficult, and improves the performance of model training.

Based on the above-mentioned first embodiment of the digital pre-distortion processing method of the present application, a second embodiment of the digital pre-distortion processing method of the present application is proposed.

In this embodiment, as shown in FIG. 4, the DPD model called by the above-mentioned DPD module comprises at least two key modules: a first data pre-processing module for at least compressing data, and a data nonlinear processing module for performing nonlinear processing on data.

Any neural network model (such as a complex MLP network, a real MLP network or an RNN network) can be used as the above-mentioned data nonlinear processing module. That is, the digital pre-distortion processing method of the present application does not specifically limit the basic structure of the nonlinear processing module.

In addition, the compressed data obtained by the DPD module calling the DPD model to pre-process the original input data comprises: first compressed data.

Based on this, the above Step S20, pre-processing the original input data to obtain compressed data may comprises:

> Step S201, using the original input data as model input of a preset DPD model;
> In this embodiment, the preset DPD model is the DPD model configured by the above-mentioned DPD module, which at least comprises a first data pre-processing module and a data nonlinear processing module as shown in FIG. 4.

In this embodiment, after the DPD module receives the original input data that needs to be power amplified by the radio-frequency power amplifier before the radio-frequency power amplifier, the DPD module first uses the original input data as the model input of the DPD model currently configured by itself.

Step S202, performing linear compression on the model input through the first data pre-processing module to obtain the first compressed data.

In this embodiment, after the DPD module uses the above-mentioned original input data as the model input of the DPD model currently configured by itself, it immediately calls the DPD model to perform compression processing on the original input data as the model input through the first data pre-processing module in the DPD model, thereby obtaining compressed data of the original input data: the first compressed data.

Exemplarily, as shown in FIG. 4, after receiving the original input data that needs to be power amplified by the radio-frequency power amplifier, the DPD module immediately uses the original input data as the model input x of the DPD model. After that, the DPD module can compress x through the first data pre-processing module to remove redundant information in the data and reduce the dimension of the data to obtain the first compressed data y. Then, the DPD module will further input the first compressed data y into the data nonlinear processing module to obtain the output data z after nonlinear processing of the first compressed data y by the data nonlinear processing module. The output data z is the data signal that the DPD module continues to pass backward to the radio-frequency power amplifier for power amplification.

In this embodiment, Q shown in FIG. 4 represents the depth of DPD model memory, that is, the dimension of the input data of the first data pre-processing module is Q+1, and the dimension of the output data y is M (there is a relationship that M is less than or equal to Q+1); the size of M reflects the effect of compressing the original input data by the first data pre-processing module: the smaller M is, the more obvious the data compression effect is.

In a feasible embodiment, the above Step S202, performing linear compression on the model input through the first data pre-processing module to obtain the first compressed data, may comprise:

performing linear compression on the model input based on a preset compression matrix through the first data pre-processing module to obtain the first compressed data.

In this embodiment, when the DPD module compresses the original input data through the first data pre-processing module in the above-mentioned DPD model, the DPD module can perform linear compression processing on the original input data through the first data pre-processing module based on the use of a preset compression matrix, thereby obtaining the first compressed data of the original input data.

Exemplarily, assuming that the compression matrix used by the first data pre-processing module in the above DPD model is C, the dimension of the compression matrix C is M rows and Q+1 columns. Based on this, after the first data pre-processing module performs linear compression processing on the original input data as the model input x to obtain the first compressed data y, the relationship between the model input x and the first compressed data y output by the first data pre-processing module can be as follows:

$$\begin{bmatrix} y_1 \\ y_2 \\ \vdots \\ y_M \end{bmatrix} = C \begin{bmatrix} x(n) \\ x(n-1) \\ \vdots \\ x(n-Q) \end{bmatrix}$$

In a feasible embodiment, the digital pre-distortion processing method of the present application may further comprise:

Step A, calculating autocorrelation matrix of the original input data;

Step B, generating a compression matrix according to the autocorrelation matrix and target output data dimension corresponding to the first data pre-processing module.

In this embodiment, before the DPD module performs linear compression processing on the original input data through the first data pre-processing module of the above-mentioned DPD model, it can further perform eigenvalue decomposition on the autocorrelation matrix of the input signal, so as to construct the compression matrix using the eigenvectors corresponding to the largest M (the dimension of the target output data corresponding to the first data pre-processing module) eigenvalues, so as to pre-construct the compression matrix C used by the first data pre-processing module.

Exemplarily, after receiving the above-mentioned original input data, the DPD module first calculates the autocorrelation matrix of the original input data. For example, assuming that the original input data is $X_i$, where $X_i$ is:

$$X_i = \begin{bmatrix} x(n+i) \\ x(n-1+i) \\ \vdots \\ x(n-Q+i) \end{bmatrix}$$

Then, the DPD module calculates the autocorrelation matrix $R_X$ of the original input data $X_i$ as:

$$R_X = E[X_i X_i^H] = \underset{i}{\mathrm{mean}}(X_i X_i^H)$$

Then, the DPD module further performs eigenvalue decomposition on the autocorrelation matrix $R_X$ as follows:

$$R_X = Q \wedge Q^H$$

$$\wedge = \begin{bmatrix} \sigma_0 & 0 & \cdots & 0 \\ 0 & \sigma_1 & \cdots & 0 \\ \vdots & \vdots & \ddots & \vdots \\ 0 & 0 & \cdots & \sigma_Q \end{bmatrix}$$

$$Q = \begin{bmatrix} v_0 & v_1 & \cdots & v_Q \end{bmatrix}$$

Among them, A is the eigenvalue matrix and Q is the eigenvalue vector matrix.

Finally, the DPD module generates a compression matrix C by selecting the eigenvectors corresponding to the largest M eigenvalues. For example, assuming that $\sigma_0 > \sigma_1 > ... \sigma_Q$, the largest M eigenvalues are $\sigma_0, \sigma_1, ..., \sigma_M$, and the eigenvectors corresponding to each of the $\sigma_0, \sigma_1, ..., \sigma_M$ are respectively $v_0, v_1, ..., v_M$, so the compression matrix C used by the first data pre-processing module in the above DPD model constructed by the DPD module can be:

$$C = \begin{bmatrix} v_0 & v_1 & \cdots & v_M \end{bmatrix}^H$$

In one implementation, since the DPD module needs to use the target output data dimension M corresponding to the first data pre-processing module in the process of constructing the compression matrix adopted by the first data pre-processing module in the above-mentioned DPD model, the DPD module may further determine the target output data dimension M corresponding to the first data pre-processing module before constructing the above-mentioned compression matrix C.

Based on this, in some feasible embodiments, the digital pre-distortion processing method of the present application may further comprises:

Step C, obtaining data before compression corresponding to the original input data based on restoration of preset restoration matrix;

Step D, calculating mean square error between the original input data and the data before compression;

Step E, determining the target output data dimension corresponding to the first data pre-processing module according to the size relationship between the mean square error and a preset error threshold.

In this embodiment, before formally constructing the compression matrix C used by the first data pre-processing module in the DPD model to perform linear compression on the original input, the DPD module first defines an initialized output data dimension M' for the first data pre-processing module, and then the first data pre-processing module performs linear compression processing on the original input data based on the compression matrix constructed using the output data dimension M' .

In this way, the DPD module can recover the data after linear compression processing by using the preset restoration matrix to obtain the data before compression corresponding to the original input data. In addition, the DPD module further calculates the mean square error between the data before compression and the original input data, and thus determines the target output data dimension M corresponding to the first data pre-processing module actually used to construct the above-mentioned compression matrix C based on the size relationship obtained by comparing the mean square error with the preset error threshold.

Exemplarily, it is assumed that the above-mentioned preset error threshold is $\mu$, and the preset restoration matrix is $C^H$. Then the DPD module first initializes the output data dimension corresponding to the first data pre-processing module to M' = Q, thus, the compression matrix $C' = [v_0 \ v_1 \cdots v_{M'}]^H$ constructed based on the output data dimension M' is used to linearly compress the original input data $X_i$ to obtain the compressed output $Y_i = CX_i$.

Afterwards, the DPD module uses the restoration matrix $C^H$ to recover the compressed output $Y_i$ to obtain the data before compression $\tilde{X}_i = C^H Y_i$. In addition, the DPD module further calculates the mean square error

$$\text{MSE} = \underset{i}{\text{mean}} \left( \left\| \tilde{X}_i - X_i \right\|^2 \right)$$ between the data before compression $\tilde{x}_i = C^H Y_i$ and the original input data $X_i$.

Finally, the DPD module determines the size relationship between the current mean square error MSE and the above-mentioned preset error threshold $\mu$. If the mean square error MSE is less than the preset error threshold $\mu$, the DPD module sets the above-mentioned output data dimension M' = M' - 1, and then returns to execute the step of "using the compression matrix $C' = [v_0 \ v_1 \cdots v_{M'}]^H$ constructed based on the output data dimension M' to linearly compress the original input data $X_i$ to obtain the compressed output $Y_i = CX_i$,", and further determines the size relationship between the new mean square error MSE and the above-mentioned preset error threshold $\mu$; If the mean square error MSE is greater than the preset error threshold $\mu$, the DPD module determines the target output data dimension M = M' + 1 corresponding to the first data pre-processing module; in addition, if the mean square error MSE is greater than the preset error threshold $\mu$, the DPD module determines the target output data dimension M = M' corresponding to the first data pre-processing module.

In a feasible embodiment, in addition to performing eigenvalue decomposition on the autocorrelation matrix of the original input data to form a compression matrix C using the eigenvector corresponding to the largest eigenvalue, the DPD module can also determine the compression matrix C used by the first data pre-processing module in the above-mentioned DPD model by a table lookup method.

Based on this, the digital pre-distortion processing method of the present application may further comprises: determining a compression matrix corresponding to signal bandwidth of the original input data from a preset compression matrix table, wherein the compression matrix table comprises a plurality of compression matrices corresponding to different signal bandwidths, respectively.

In this embodiment, the preset compression matrix table is a table maintained by the DPD module for pre-generated compression matrices under different signal bandwidths. The compression matrix table comprises a plurality of compression matrices corresponding to different signal bandwidths, respectively.

Based on this, before the DPD module performs linear compression processing on the original input data through the first data pre-processing module of the above-mentioned DPD model, the DPD module can use the signal bandwidth of the original input data as an index to index the compression matrix corresponding to the signal bandwidth from the above-mentioned compression matrix table, as the compression matrix C used by the above-mentioned first data pre-processing module when performing linear compression processing on the original input data.

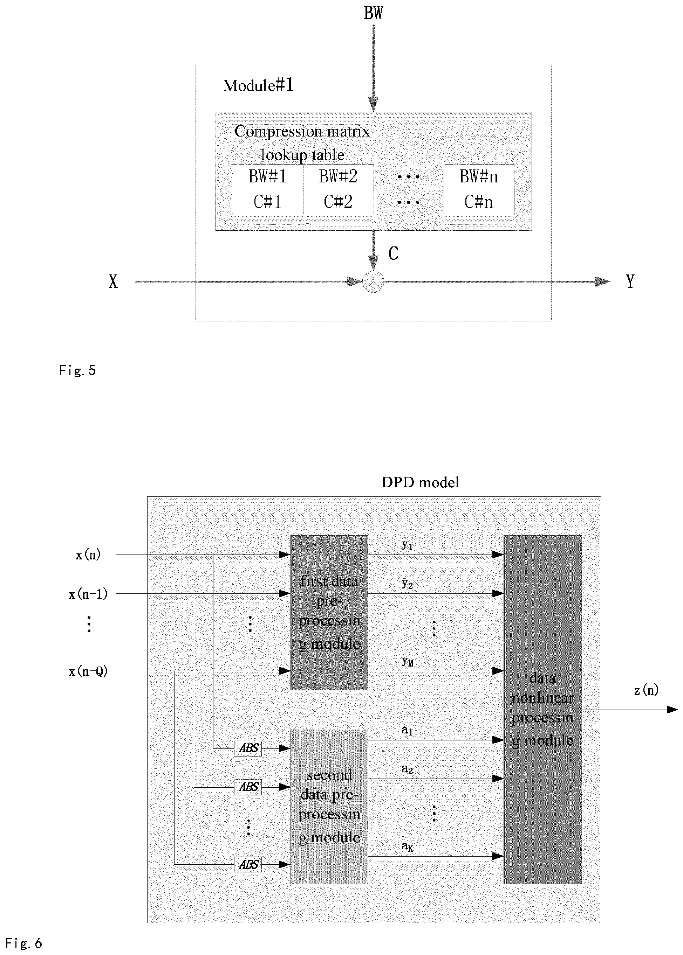

Exemplarily, as shown in FIG. 5 (in which BW represents bandwidth information), since the compression matrix is associated with the autocorrelation matrix of the original input data, and the autocorrelation matrix is associated with the signal bandwidth of the original input data, the compression matrix will not change essentially as long as the bandwidth of the signal does not change. Based on this, the DPD module can pre-generate compression matrices under various signal bandwidths and maintain the table of compression matrices under the different signal bandwidths, thereby using the signal bandwidth of the original input data received at the current moment as an index, and searching the pre-maintained table for the compression matrix C that needs to be used by the first data pre-processing module to perform linear compression processing on the original input data at the current moment.

In this embodiment, the DPD module determines the compression matrix C by table lookup method, and does not need to recalculate it every time. In this way, the digital pre-distortion processing method of the present application can further improve the response enthusiasm of the DPD model to the compression processing of the original input data.

Based on the first embodiment and/or the second embodiment of the digital pre-distortion processing method of the present application, a third embodiment of the digital pre-distortion processing method of the present application is proposed.

In this embodiment, as shown in FIG. 6, the DPD model called by the above-mentioned DPD module comprises three key modules: a first data pre-processing module and a second data pre-processing module for at least performing compression processing on data, and a data nonlinear processing module for performing nonlinear processing on data.

In addition, the compressed data obtained by the DPD module calling the DPD model to pre-process the original input data also comprises: second compressed data.

Based on this, the digital pre-distortion processing method of the present application may further comprise:

compressing the modulus value of the model input through the second data pre-processing module to obtain the second compressed data;

performing nonlinear processing on the first compressed data and the second compressed data through the DPD model.

In this embodiment, after the DPD module uses the above-mentioned original input data as the model input of the DPD model currently configured by itself, in addition to calling the DPD model to pass through the first data pre-processing module in the DPD model, and using only the first data pre-processing module to perform compression processing on the original input data as the model input, it is also possible to synchronously or asynchronously compress the modulus value of the original input data as the model input through the second data pre-processing module in the DPD model to obtain the second compressed data of the original input data.

In this way, the DPD module can further call the DPD model to perform nonlinear processing on the first compressed data and the second compressed data through the data nonlinear processing module in the DPD model.

Exemplarily, as shown in FIG. 6, after receiving the original input data that needs to be amplified by the radio-frequency power amplifier, the DPD module immediately uses the original input data as the model input x of the DPD model, and uses the original input data as the model input abs(x) at the modulus value. After that, the DPD module can compress x through the first data pre-processing module to remove redundant information in the data and reduce the dimension of the data to obtain the first compressed data y, and synchronously or asynchronously compress abs(x) through the second data pre-processing module to remove redundant information in the data and reduce the dimension of the data to obtain the second compressed data a.

Then, the DPD module further inputs the first compressed data y and the second compressed data a into the data nonlinear processing module, so as to obtain the output data z after nonlinear processing of the first compressed data y and the second compressed data a through the data nonlinear processing module. The output data z is the data signal that the DPD module continues to pass backwards to the radio-frequency power amplifier for power amplification.

In this embodiment, similarly, Q shown in FIG. 6 represents the depth of DPD model memory, that is, the dimension of the input data of the second data pre-processing module is Q+1, and the dimension of the output data a is K at this time (there is also a relationship that K is less than or equal to Q+1); the size of K also reflects the effect of compressing the original input data by the second data pre-processing module: the smaller K is, the more obvious the data compression effect is.

In addition, the process of compressing the modulus value of the original input data by the above-mentioned second data pre-processing module is consistent with the process of compressing the original input data by the above-mentioned first data pre-processing module, and determining the compression matrix (assumed to be $C_{abs}$) used by the second data pre-processing module to compress the modulus value of the original input data is also consistent with the above-mentioned process of determining the compression matrix C used by the first data pre-processing module, and the process of determining the target output data dimension K used by the second data pre-processing module to construct the compression matrix $C_{abs}$ is also consistent with the above-mentioned process of determining the target output data dimension M corresponding to the first data pre-processing module.

Therefore, the process of linearly compressing the module value of the original input data by the second data pre-processing module, constructing or determining the compression matrix $C_{abs}$ used by the second data pre-processing module through a table lookup method, and determining the target output data dimension K corresponding to the second data pre-processing module will not be described here in detail.

In one implementation, an optional embodiment of the digital pre-processing method of the present application is proposed by using a DPD module by adopting a DPD model as shown in FIG .7.

In this embodiment, the first data pre-processing module and the second data pre-processing module of the DPD model both use a linear compression scheme to perform compression processing on their respective model inputs, wherein the compression matrix used by the first data pre-processing module is a compression matrix C, and the compression matrix used by the second data pre-processing module is a compression matrix $C_{abs}$. In addition, the memory depth of the DPD model is 9, and the input dimension of the original input data X is 10, that is:

$$X = \begin{bmatrix} x(n) \\ x(n-1) \\ \vdots \\ x(n-9) \end{bmatrix}.$$

In addition, the dimension of the compression matrix C is 10×5. Thus, the first compressed data Y output by the first data pre-processing module after linear compression of the original input data X is:

$$Y = \begin{bmatrix} y_1 \\ y_2 \\ \vdots \\ y_5 \end{bmatrix}.$$

Similarly, the dimension of the compression matrix $C_{abs}$ is 10×5, so the second compressed data A output by the second data pre-processing module after linear compression of the modulus value of the original input data X is:

$$A = \begin{bmatrix} a_1 \\ a_2 \\ \vdots \\ a_5 \end{bmatrix}.$$

In addition, in this embodiment, the above-mentioned second data pre-processing module can specifically be a complex MLP (Multilayer Perceptron, fully connected neural network, also called multilayer perceptron) network, wherein the input layer unit of the MLP is 10 (matching the output of the previous level module), the number of output layer units is 1, comprising 4 hidden layers, each hidden layer has 10 units, and the activation function is f(x)=tanh(real(x))+i·tanh(imag(x)).

Based on the above settings, the number of parameters of the DPD model is 451.

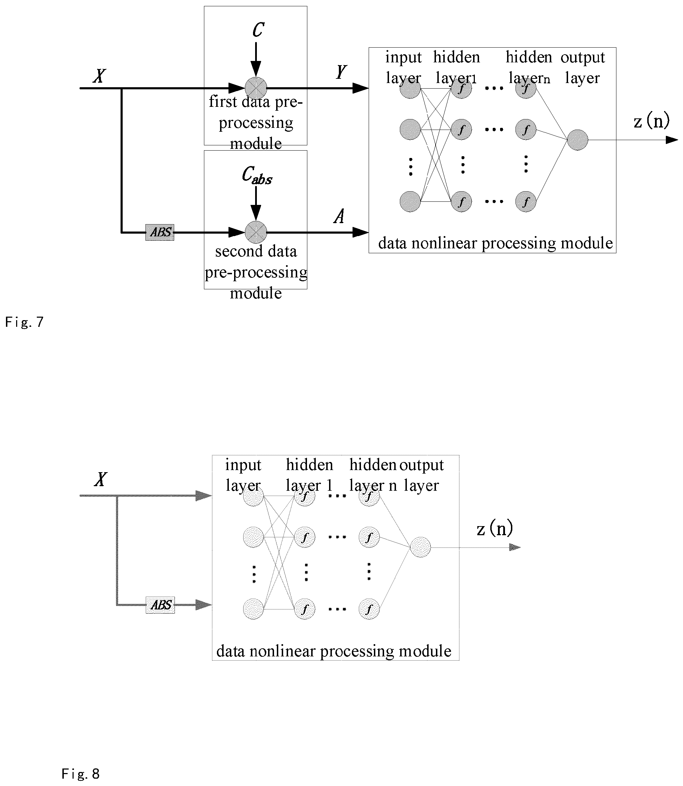

In one implementation, the conventional DPD model based on a neural network as shown in FIG. 8 is used as a comparison object, that is, the DPD model based on a neural network does not process the original input data in any way, but directly uses the original input data and the modulus of the original input data as the input of the neural network to be processed by the data nonlinear processing module. At this time, the data nonlinear processing module increases the number of input units to 20 to match the dimension of the original input data compared to the nonlinear processing module shown in FIG. 6 above. In this way, the number of parameters of the conventional DPD model based on a neural network as shown in FIG. 7 is determined to be 551.

In one implementation, a signal with a bandwidth of 100M is used as a signal source to test the above two DPD models. Each time, the parameters of the neural network are initialized with different random seeds, and the two models are tested 50 times respectively. The average values of the test results of the two models are shown in the following Table:

| DPD MODEL | Train_NMSE | Test_NMSE | ACLR_L | ACLR_R |
|---|---|---|---|---|
| The model shown in FIG. 6 | - 48.9989 | - 48.9775 | - 55.3394 | - 55.1335 |
| Conventional model shown in FIG. 7 | - 48.1998 | - 48.1203 | - 55.2064 | - 54.1533 |

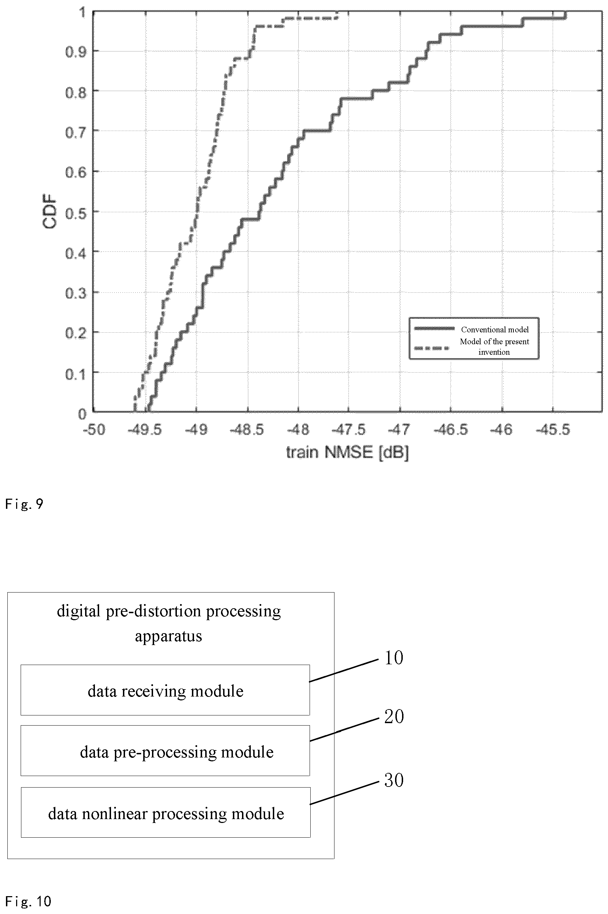

Among them, the CDF curve of train_NMSE in the test results is shown in FIG. 9.

From the comparison of the average values of the above test results, it can be seen that the DPD model adopted by the digital pre-distortion processing method of the present application as shown in FIG. 7 significantly reduces the number of parameters (from 551 to 451) compared to the existing conventional neural network-based DPD model as shown in FIG. 8. At the same time, it also improves the average train_NMSE performance by about 0.8 dB, and does not bring any negative impact.

From the comparison of the statistical CDF curves, it can be seen that the DPD model adopted in the digital pre-distortion processing method of the present application greatly improves the performance lower limit of the model. The worst performance of the DPD model adopted in the digital pre-distortion processing method of the present application has a gain of up to 2dB compared with the conventional model, which indicates that the DPD model adopted by the digital pre-distortion processing method of the present application has stronger robustness.

In addition, the embodiment of the present application also proposes a digital pre-distortion processing apparatus.

Referring to FIG. 4, the digital pre-distortion processing apparatus of the present application comprises:

a data receiving module 10, which is configured to receive original input data of a radio-frequency power amplifier;

a pre-processing module 20, which is configured to pre-process the original input data to obtain compressed data; and

a data nonlinear processing module 30, which is configured to perform nonlinear processing on the compressed data, so as to obtain output data as actual input data of the radio-frequency power amplifier.

In one implementation, the compressed data comprises first compressed data, and the data pre-processing module 20 comprises:

a data input unit, which is configured to use the original input data as a model input of a preset DPD model, wherein the DPD model comprises a first data pre-processing module;

a first compression unit, which is configured to compress the model input through the first data pre-processing module to obtain the first compressed data.

In one implementation, the first compression unit is further used to perform linear compression on the model input based on a preset compression matrix through the first data pre-processing module to obtain the first compressed data.

In one implementation, the digital pre-distortion processing apparatus of the present application further comprises:
a compression matrix determination module, which is configured to calculate autocorrelation matrix of the original input data; and generate a compression matrix according to the autocorrelation matrix and target output data dimension corresponding to the first data pre-processing module.

In one implementation, the digital pre-distortion processing apparatus of the present application further comprises:
a data dimension determination module, which is configured to obtain data before compression corresponding to the original input data based on restoration of preset restoration matrix; calculate mean square error between the original input data and the data before compression; and determine the target output data dimension corresponding to the first data pre-processing module according to the size relationship between the mean square error and a preset error threshold.

In one implementation, the compression matrix determination module of the digital pre-distortion processing apparatus of the present application, is further configured to determine a compression matrix corresponding to signal bandwidth of the original input data from a preset compression matrix table, wherein the compression matrix table comprises a plurality of compression matrices corresponding to different signal bandwidths, respectively.

In one implementation, the compressed data further comprises second compressed data, and the DPD model further comprises a second data pre-processing module; the data pre-processing module 20 of the digital pre-distortion processing apparatus of the present application further comprises:
a second compression unit, which is configured to compress the modulus value of the model input through the second data pre-processing module to obtain the second compressed data;

The data nonlinear processing module 30 of the digital pre-distortion processing apparatus of the present application is further configured to perform nonlinear processing on the first compressed data and the second compressed data through the DPD model.

Wherein, the functional implementation of each module in the above-mentioned digital pre-distortion processing apparatus of the present application corresponds to each step in the above-mentioned embodiment of the digital pre-distortion processing method of the present application, and its functions and implementation processes are not repeated here one by one.

In addition, the present application further provides a computer storage medium, on which a digital pre-distortion processing program is stored. When the digital pre-distortion processing program is executed by a processor, the steps of the digital pre-distortion processing method described in any of the above embodiments are implemented.

The specific embodiments of the computer storage medium of the present application are basically the same as the embodiments of the digital pre-distortion processing method described above, and will not be described in detail here.

In addition, the present application also provides a computer program product, which comprises a computer program, and when the computer program is executed by a processor, the steps of the digital pre-distortion processing method described in any of the above embodiments are implemented.

The specific embodiments of the computer program product of the present application are basically the same as the embodiments of the digital pre-distortion processing method described above, and will not be described in detail here.

The above are only optional embodiments of the present application, and do not limit the patent scope of the present application. Any equivalent structure or equivalent process transformation made by using the contents of the present application specification and drawings, or directly or indirectly applied in other related technical fields, are also included in the patent protection scope of the present application.

**Claims**

1. A digital pre-distortion processing method, wherein the digital pre-distortion processing method comprises:

    receiving original input data of a radio-frequency power amplifier;
    pre-processing the original input data to obtain compressed data; and
    performing nonlinear processing on the compressed data, so as to obtain output data as actual input data of the radio-frequency power amplifier.

2. According to the processing method of claim 1, wherein the compressed data comprises first compressed data, and pre-processing the original input data to obtain compressed data comprises:

    using the original input data as model input of a preset DPD model, wherein the DPD model comprises a first data pre-processing module;
    compressing the model input through the first data pre-processing module to obtain the first compressed data.

3. According to the processing method of claim 2, wherein compressing the model input through the first data pre-processing module to obtain the first compressed data comprises:
   performing linear compression on the model input based on a preset compression matrix through the first data pre-processing module to obtain the first compressed data.

4. According to the processing method of claim 3, wherein the processing method further comprises:

    calculating autocorrelation matrix of the original input data;
    generating a compression matrix according to the autocorrelation matrix and target output data dimension corresponding to the first data pre-processing module.

5. According to the processing method of claim 4, wherein the processing method further comprises:

    obtaining data before compression corresponding to the original input data based on restoration of preset restoration matrix;
    calculating mean square error between the original input data and the data before compression;
    determining the target output data dimension corresponding to the first data pre-processing module according to the size relationship between the mean square error and a preset error threshold.

6. According to the processing method of claim 3, wherein the processing method further comprises:
   determining a compression matrix corresponding to signal bandwidth of the original input data from a preset compression matrix table, wherein the compression matrix table comprises a plurality of compression matrices corresponding to different signal bandwidths, respectively.

7. According to any one of the processing method of claims 2 to 6, wherein the compressed data further comprises second compressed data, and the DPD model further comprises a second data pre-processing module;
   the processing method further comprises:

compressing the modulus value of the model input through the second data pre-processing module to obtain the second compressed data; and

performing nonlinear processing on the first compressed data and the second compressed data through the DPD model.

8. A digital pre-distortion processing apparatus, wherein the digital pre-distortion processing apparatus comprises:

a data receiving module, configured to receive original input data of a radio-frequency power amplifier;

a pre-processing module, configured to pre-process the original input data to obtain compressed data; and

a data nonlinear processing module, configured to perform nonlinear processing on the compressed data, so as to obtain output data as actual input data of the radio-frequency power amplifier.

9. A terminal device, wherein the terminal device comprises: a memory, a processor, and a digital pre-distortion processing program stored in the memory and executable on the processor, when the digital pre-distortion processing program is executed by the processor, implementing the steps of the digital pre-distortion processing method according to any one of claims 1 to 7.

10. A computer storage medium, wherein a digital pre-distortion processing program is stored on the computer storage medium, and when the digital pre-distortion processing program is executed by a processor, implementing the steps of the digital pre-distortion processing method according to any one of claims 1 to 7.

1005

1001

1002

processor

operating system

network communication module

1003

1004

user interface module

digital pre-distortion processing program

user interface

network interface

memory

Fig. 1

$x$ → DPD → $z$ → PA → $y$

$z$ / $x$

$y$ / $z$

$y$ / $x$

Fig. 2

receiving original input data of a radio-frequency power amplifier ⟍ S10

pre-processing the original input data to obtain compressed data ⟍ S20

performing nonlinear processing on the compressed data, so as to obtain output data as actual input data of the radio-frequency power amplifier ⟍ S30

Fig. 3

DPD model

$x(n)$

$x(n-1)$

⋮

$x(n-Q)$

first data pre-processing module

$y_1$

$y_2$

⋮

$y_M$

data nonlinear processing module

$z(n)$

Fig. 4

BW

Module#1

Compression matrix
lookup table

| BW#1 | BW#2 | ⋯⋯ | BW#n |
|------|------|------|------|
| C#1 | C#2 | ⋯⋯ | C#n |

C

X ⊗ Y

Fig. 5

DPD model

x(n)

x(n-1)

⋮

x(n-Q)

first data pre-processing module

$y_1$
$y_2$
⋮
$y_M$

ABS
ABS
⋮
ABS

second data pre-processing module

$a_1$
$a_2$
⋮
$a_K$

data nonlinear processing module

z(n)

Fig. 6

Fig. 7

Fig. 8

Fig. 9

digital pre-distortion processing apparatus

data receiving module — 10

data pre-processing module — 20

data nonlinear processing module — 30

Fig. 10

## INTERNATIONAL SEARCH REPORT

International application No.

**PCT/CN2023/105402**

| A. | CLASSIFICATION OF SUBJECT MATTER |
|---|---|

H04L 25/49(2006.01)i

According to International Patent Classification (IPC) or to both national classification and IPC

| B. | FIELDS SEARCHED |
|---|---|

Minimum documentation searched (classification system followed by classification symbols)

IPC:H04L

Documentation searched other than minimum documentation to the extent that such documents are included in the fields searched

Electronic data base consulted during the international search (name of data base and, where practicable, search terms used)

DWPI, ENTXT, CNTXT, CJFD: 数字预失真处理, 射频功放, 压缩, 非线性, 维度, digital pre-distortion, DPD, frequency, power, amplifier, PA, compress, nonlinear, dimensionality

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | US 2022200618 A1 (INTEL CORP.) 23 June 2022 (2022-06-23) description, paragraphs [0016]-[0077] | 1-10 |
| Y | CN 106572039 A (ANALOG DEVICES, INC.) 19 April 2017 (2017-04-19) description, paragraphs [0023]-[0059] | 1-10 |
| Y | US 2018331662 A1 (MEDIATEK INC.) 15 November 2018 (2018-11-15) description, paragraphs [0012]-[0027] | 1-10 |
| A | CN 104170008 A (TELEFONAKTIEBOLAGET LM ERICSSON (PUBL)) 26 November 2014 (2014-11-26) entire document | 1-10 |
| A | CN 110943947 A (VIVO MOBILE COMMUNICATION CO., LTD.) 31 March 2020 (2020-03-31) entire document | 1-10 |

☐ Further documents are listed in the continuation of Box C.   ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **15 September 2023** | **10 October 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/105402**

| Patent document cited in search report | | | Publication date (day/month/year) | Patent family member(s) | | | Publication date (day/month/year) |
|---|---|---|---|---|---|---|---|
| US | 2022200618 | A1 | 23 June 2022 | EP | 4020802 | A1 | 29 June 2022 |
| CN | 106572039 | A | 19 April 2017 | EP | 3166223 | A2 | 10 May 2017 |
| | | | | US | 2017104503 | A1 | 13 April 2017 |
| | | | | US | 2017104502 | A1 | 13 April 2017 |
| | | | | CN | 106572038 | A | 19 April 2017 |
| | | | | EP | 3157168 | A1 | 19 April 2017 |
| | | | | JP | 2017121059 | A | 06 July 2017 |
| US | 2018331662 | A1 | 15 November 2018 | None | | | |
| CN | 104170008 | A | 26 November 2014 | WO | 2013136109 | A1 | 19 September 2013 |
| | | | | US | 2014254656 | A1 | 11 September 2014 |
| | | | | US | 2013243074 | A1 | 19 September 2013 |
| | | | | EP | 2847762 | A1 | 18 March 2015 |
| CN | 110943947 | A | 31 March 2020 | None | | | |

Form PCT/ISA/210 (patent family annex) (July 2022)

**EP 4 604 461 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211544594